# EUROPÄISCHE PATENTSCHRIFT

(11) **EP 1 087 646 B1**
(45) Veröffentlichungstag und Bekanntmachung des Hinweises auf die Patenterteilung: **09.07.2008**
(21) Anmeldenummer: 00117046.3
(22) Anmeldetag: 09.08.2000
(51) Int. Cl.: H05K 1/09, H01B 1/16, C03C 17/06

(54) **Verfahren zur Herstellung einer leitfähigen Beschichtung auf Glas oder emailliertem Stahl und hiernach beschichtete Substrate**
Process for producing a conductive coating on glass or enamelled steel and substrates coated thereby
Procédé de production d'un revêtement conducteur sur du verre ou de l'acier émaillé et des substrats ainsi revêtus

(30) Priorität: 24.09.1999 DE 19945866
(43) Veröffentlichungstag der Anmeldung: 28.03.2001
(73) Patentinhaber: Ferro GmbH, 60327 Frankfurt (DE)
(72) Erfinder: Niemann, Axel, 60385 Frankfurt (DE); Roche, Guy, 87170 Isle (FR)
(74) Vertreter: Reinhardt, Markus

(56) Entgegenhaltungen:
- DE-A1- 2 444 689
- US-A- 4 039 721
- US-A- 4 053 864
- US-A- 4 070 517
- US-A- 4 207 369
- US-A- 4 255 291
- US-A- 4 450 346

## Beschreibung

Die Erfindung betrifft ein Verfahren zur Herstellung der leitfähigen Beschichtung, insbesondere Leiterbahnen, und hiernach beschichtete Substrate aus der Reihe Glas und emailliertem Stahl. Verwendet wird eine siebdruckfähige Aluminiumpaste auf der Basis von Aluminiumpulver, mindestens einer Glasfritte und einem organischen Medium. Weitere Gegenstände betreffen verfahrensgemäß erhältliche beschichtete Substrate.

Glasscheiben und keramische Substrate für Elektronikzwecke werden für unterschiedliche Zwecke oft partiell oder ganzflächig mit einer leitfähigen Schicht versehen, wobei die Beschichtung ein Metall als Leitfähgkeit vermittelnde Komponente und eine Glaszusammensetzung als Bindemittel enthält. Derartige Beschichtungen basieren oft auf Edelmetallen, wie beispielsweise Silber im Falle von Leiterbahnen auf Glas oder Gold und/oder Platinmetalle im Falle von Leiterbahnen oder Elektroden auf keramischen Substraten, wie Halbleiterkeramik.

Die Herstellung solcher Leiterbahnen umfasst das Aufbringen einer Metallpulver und eine Glasfritte enthaltenden flüssigen oder pastösen Zusammensetzung und einen sich anschließenden Brand bei einer auf das Substrat abgestimmten Brenntemperatur.

Während zur Herstellung leitfähiger Beschichtungen auf keramischen Substraten die Edelmetalle teilweise durch Aluminium ersetzt werden konnten, war es bisher nicht möglich, qualitativ hochwertige Leiterbahnen auf Aluminiumbasis auf Glasscheiben herzustellen. Bekannte, ausschließlich Aluminiumpulver als Leitfähigkeitskomponente enthaltende Zusammensetzungen erfordern eine für Glas zu hohe Einbrenntemperatur und/oder führen zu einer Beschichtung mit ungenügender Haftung und/oder ungenügender Leitfähigkeit.

Das US-Patent 3,833,348 lehrt ein Verfahren zur Verbindung von zwei Siliciumnitridteilen. Eine hierfür zu verwendende Zusammensetzung basiert auf einer Glasfritte und Aluminium. Die bevorzugten Glasfritten auf der Basis von SiO₂, Al₂O₃ und MnO weisen einen zur Anwendung auf Glas zu hohen Schmelzpunkt auf.

Aus dem US-Patent 5,562,972 ist eine Leitfähigkeitspaste zur Herstellung feuchtigkeitsresistenter Elektroden mit günstigem Ohm'schen Kontakt zwischen der Elektrode und einem Halbleiterelement bekannt. Die Paste enthält Aluminiumpulver und eine Glasfritte auf der Basis von Bariumborosilikat oder/und Calciumborosilikat in einer Menge von 5 bis 40 Gew.-%, bezogen auf Aluminium. Auch diese Pasten lassen sich wegen ihres hohen Schmelzpunktes nicht auf Glas applizieren.

Die Aluminiumpulver und Glasfritte enthaltende Zusammensetzung gemäß US-Patent 5,856,015 enthält zwar eine Glasfritte mit einem dilatometrischen Erweichungspunkt unter 600 °C, jedoch handelt es sich um eine Glasur für ein keramisches Substrat. Der Aluminiumgehalt in dieser Glasur mit maximal 30 Gew.-% ist für die Anwendung als Leitfähgkeitspaste zu niedrig, um eine ausreichende Leitfähigkeit zu gewährleisten.

Gemäß US-Patent 4,039,721 werden Dickschicht-Leiterbahnen auf einem keramischen Substrat erhalten, indem eine Paste aus 3 bis 28 Gew.-% Silberpulver, 30 bis 61 Gew.-% Aluminiumpulver, 24 bis 44 Gew.-% Borosilikat-Glasfritte auf das Substrat mittels Siebdruck aufgebracht und innerhalb von 0,2 bis 1 h bei 850 bis 1050 °C eingebrannt wird. Obgleich anspruchsgemäß von einem "glasigen Substrat" die Rede ist, werden beispielsgemäß nur keramische Substrate eingesetzt. Die Brenntemperatur spricht gegen die Verwendung der Paste auf Glasscheiben. Um eine ausreichende Leitfähigkeit zu erzielen, muß neben Aluminium zusätzlich Silber eingesetzt werden.

Aus dem US-Patent 5,358,666 ist ein Ohm'sches Elektrodenmaterial bekannt, das aus 10 bis 50 Gew.-% Glasfritte aus der Reihe Zink-borosilikat und Blei-zink-borosilikat und einer Leitfähigkeitskomponente aus 48 bis 96 Gew.-% Aluminium und 4 bis 52 Gew.-% Silicium besteht. Diese Bestandteile werden in Form einer Paste in einem organischen Medium auf ein keramisches Substrat appliziert und bei 600 bis 800 °C eingebrannt. Um eine ausreichende Stabilität des spezifischen Widerstands auch nach einer Lagerung in feuchter Atmosphäre sicherzustellen, muß die Paste zwingend Silicium enthalten. Dieses Dokument richtet sich nicht auf Leitfähigkeitsbahnen auf Glas.

Das Dokument US 4,070,517 beschreibt eine Aluminiumpaste, die eine bleihaltige Glasfritte umfasst. Siebdruckfähige Pasten, die einen hohen Aluminiumgehalt und ein bleifreie Glasfritte umfassen, werden in US 4,070,517 nicht beschrieben.

Aufgabe der vorliegenden Erfindung ist es demgemäß, ein Verfahren aufzuzeigen, womit unter Einsatz einer Metallpulver und Glasfritte enthaltende Paste leitfähige Beschichtungen auf Substraten, wie Glas und emailliertem Stahl, wie Leiterbahnen auf Glas, hergestellt werden können. Die zu verwendende Paste sollte vorzugsweise silberfrei sein und sich nach dem Auftragen auf Glas unter üblichen Brennbedingungen, wie insbesondere dem bei Automobil-Glasscheiben üblichen Schockbrand, einbrennen lassen und zu gut haftenden leitfähigen Schichten führen. Gemäß einer weiteren Aufgabe sollte ein erfindungsgemäß erhältliches, mit einer leitfähigen Beschichtung versehenes Glassubstrat, wie insbesondere Glasscheibe, bereitgestellt werden, wobei die Beschichtung durch einen spezifischen Widerstand von weniger als 100 µOhm · cm und vorzugsweise weniger als 50 µOhm · cm bei gleichzeitig guter Haftung gekennzeichnet sein sollte.

Die genannten Aufgaben und weitere aus der folgenden Offenbarung sich ergebenden Aufgaben werden durch das anspruchsgemäße Verfahren zur Herstellung einer leitfähigen Beschichtung und das anspruchsgemäße mit einer leitfähigen Aluminiumschicht beschichtete Substrat, bei dem es sich um Glas, insbesondere Automobil-Glasscheiben, oder emaillierten Stahl handelt.

Gefunden wurde demgemäß ein Verfahren zur Herstellung einer leitfähigen Beschichtung, insbesondere Leiterbahnen, auf einem Substrat aus der Reihe Glas und emailliertem Stahl, umfassend Aufbringen einer Schicht aus einer ein Metallpulver, mindestens eine bleifreie Glasfritte und ein flüssiges oder thermoplastisches Medium enthaltenden Paste auf das Substrat und Einbrennen der Beschichtung bei einer Temperatur im Bereich von 500 bis 750 °C, das dadurch gekennzeichnet ist, dass man eine siebdruckfähige Aluminiumpaste verwendet, welche (i) Aluminiumpulver mit einem d₅₀-Wert im Bereich von 1 bis 10 µm in einer Menge von 40 bis 80 Gew.-%, (ii) eine oder mehrere Glasfritten mit einem Erweichungsbeginn im Bereich von 400 bis 700 °C und einem d₅₀-Wert im Bereich von 1 bis 10 µm in einer Menge von 5 bis 40 Gew.-%, wobei eine oder mehrere Glasfritten eine Zusammensetzung mit
10-25 Gew.-% SiO₂,
20-40 Gew.-% B₂O₃,
10-50 Gew.-% ZnO,
0-15 Gew.-% Bi₂O₃,
7-15 Gew.-% Na₂O,
3-8 Gew.-% Al₂O₃,
0-2 Gew.-% F und gegebenenfalls fakultativen Oxiden aufweisen, (iii) ein flüssiges oder thermoplastisches Medium aus einem oder mehreren Polymeren und/oder Lösungsmitteln in einer Gesamtmenge von 10 bis 35 Gew.-%, (iv) Sinterhilfsmittel in Pulverform in einer Menge von 0 bis 10 Gew.-% und (v) 0 bis 40 Gew.-% Silberpulver enthält.

Die Aluminiumpaste lässt sich mittels Siebdruck oder in anderer aus der Dekorationstechnik bekannter Weise in Form dünner Schichten auf das Substrat aufbringen. Der Begriff siebdruckfähig umfasst den direkten Druck auf das Substrat und die Abziehbildtechnik.

Überraschenderweise lassen sich die erfindungsgemäß zu verwendenden Aluminiumpasten in Luftatmosphäre problemlos, auch im Schockbrand, auf Glas als Substrat einbrennen, wobei gut haftende leitfähige Schichten auf Aluminiumbasis mit einem spezifischen Widerstand von weniger als 100 µOhm · cm erhalten. In Abhängigkeit von der in der Paste eingesetzten Glasfritte sind auch Schichten mit einem spezifischen Widerstand unter 70 µOhm · cm erhältlich, und besonders bevorzugte Pasten führen zu einem spezifischen Widerstand im Bereich von 20 bis 50 µOhm · cm. Überraschenderweise zeichnen sich die eingebrannten leitfähigen Schichten auch durch eine hohe Haftfestigkeit aus - der Kratzwiderstand ist über 20 N, bestimmt mittels Erichsen Stift, der über eine erfindungsgemäß hergestelle Leiterbahn auf Glas gezogen wird. Dieser Kratzwiderstand bleibt auch nach 5-tägiger Lagerung bei 70 °C und 90 % relativer Feuchte im wesentlichen erhalten. Die positiven Eigenschaften lassen sich mit bleifreien Glasfritten in der Aluminiumpaste erzielen, wobei unter Einsatz zinkhaltiger Glasfritten überraschenderweise sogar noch bessere Werte erhältlich sind.

Nicht vorhersehbar war auch, und dies ist ein besonderer Vorteil, dass unter Einsatz bevorzugter Aluminiumpasten mit einer Zinkborosilikat-Glasfritte der spezifische Widerstand innerhalb eines Bereichs von etwa ± 20 °C unter- oder oberhalb der üblichen Brenntemperatur im wesentlichen konstant bleibt.

Die Aluminiumpasten enthalten vorzugsweise mindestens 50 Gew.-%, insbesondere 50 bis 75 Gew.-% Al-Pulver. Eingesetzt werden vorzugsweise körnige, insbesondere kugelförmige Al-Pulver. Im Handel erhältliches Al-Pulver in Blättchenform ist wegen seines großen Blättchendurchmessers (d₉₀ gleich/größer 30 µm) wenig geeignet. Zweckmäßigerweise liegt der d₅₀-Wert im Bereich von 1 bis 10 µm, insbesondere 1 bis 8 µm. Der d₁₀-Wert sollte größer 0,2 µm, insbesondere größer 0,5 µm sein und besonders bevorzugt im Bereich von 0,5 bis 2 µm liegen, vorzugsweise unter 15 µm. Üblicherweise liegt die spezifische Oberfläche des Al-Pulvers im Bereich von 0,5 bis 5 m²/g, jedoch können diese Grenzen im Einzelfall auch unter- oder überschritten werden. Mit zunehmender spezifischer Oberfläche des Al-Pulvers wird allerdings die Anpastbarkeit erschwert, und macht ggf. eine Reduzierung des Al-Gehalts erforderlich. Besonders bevorzugte Al-Pulver sind kugelförmig, weisen einen d₅₀-Wert um 5 µm (± 2 µm), einen d₉₀-Wert unter 15 µm und einen d₁₀-Wert über 1 µm und eine spezifische Oberfläche im Bereich von 0,5 bis 3 m²/g auf. Ein Teil des Al-pulvers kann auch durch Silberpulver ersetzt sein, bevorzugt werden jedoch im wesentlichen silberfreie Pasten.

Die in der Al-Paste eingesetzten Glasfritten haben sowohl bezüglich der Einsatzmenge als auch bezüglich der chemischen Zusammensetzung einen großen Einfluss auf die Eigenschaften der eingebrannten Al-Beschichtung. Ein wesentliches Merkmal der Glasfritte ist die Temperatur des Erweichungsbeginns. Diese lässt sich unter Einsatz eines Probekörpers im Erhitzungsmikroskop bestimmen. Der Erweichungsbeginn erfindungsgemäß zu verwendender Glasfritten liegt vorzugsweise im Bereich von 400 bis 700 °C, insbesondere 400 bis 650 °C und besonders bevorzugt bei 420 bis 580 °C.

Die Glasfritten werden in für Siebdruckzwecke üblicher Körnung eingesetzt. Üblicherweise liegt der d₅₀-Wert im Bereich von 0,5 bis 10 µm, vorzugsweise im Bereich von 1 bis 5 µm. Zweckmäßigerweise ist der d₉₀-Wert kleiner 15 µm, insbesondere kleiner 10 µm und der d₁₀-Wert größer 0,2 µm, vorzugsweise größer 0,5 µm.

Die Einsatzmenge Glasfritte in der Al-Paste kann im Bereich von 5 bis 40 Gew.-% liegen, bevorzugt wird aber ein Bereich von 5 bis 30 Gew.-% und besonders bevorzugt 9 bis 25 Gew.-%. Die bezüglich der erreichbaren Eigenschaften einer eingebrannten Al-Beschichtung optimale Einsatzmenge hängt wiederum in erheblichem Umfang von der Zusammensetzung der Glasfritte ab. Zinkborosilikatfritten ergeben bei einem besonders niedrigen Frittegehalt von 10 bis 15 Gew.-% bereits einen außergewöhlich niedrigen spezifischen Widerstand bei hervorragender Haftung.

Erfindungsgemäß einzusetzende Zinkborosilikatfritten (siehe Beispiel 3) zur Herstellung von Leiterbahnen auf Glas mit außergewöhnlich niedrigem spezifischen Widerstand und sehr guter Haftung weisen folgende Zusammensetzungen (in Gew.-%) auf: SiO₂ 10-25, B₂O₃ 20-40, ZnO 10-50, Bi₂O₃ 0-15, Na₂O 7-15, Al₂O₃ 3-8, F 0-2 und fakultative Oxide, wie CaO, TiO₂ und ZrO₂.

Zusätzlich Einsetzbar sind optional andere bleifreie Glasfritten. Unter den bleifreien Glasfritten sind zinkhaltige, bismuthaltige oder zink- und bismuthaltige Glasfritten sowie Glasfritten auf Basis SiO₂, B₂O₃, TiO₂ oder Al₂O₃ und K₂O geeignet. Der Fachwelt sind derartige Glasfritten, bei denen es sich insbesondere um Borosilikatfritten handelt, die auch im geforderten Temperaturbereich erweichen, bekannt. Beispielhafte Frittezusammensetzungen enthalten als Basis obligatorische Komponenten:
EP 0 790 220 B (in Mol-%): SiO₂ 30-55, B₂O₃ 10-25, TiO₂ 15-30, K₂O 10-17;
EP 0 728 710 B (in Mol-%): SiO₂ 40-50, B₂O₃ 8-14, ZnO 13-19, TiO₂ 4-7, Na₂O 10-15, K₂O 0,1-2, F 1-5, Al₂O₃ 0,1-3;
EP 0 267 154 B (in Mol-%): SiO₂ 45-60, B₂O₃ 6-13, ZnO 8-25, Na₂O 5-14;
EP 0 558 942 (in Mol-%): SiO₂ 10-44, B₂O₃ 11-35, ZnO 31-50, Na₂O 11-25;
EP 0 854 120 A (in Gew.-%): SiO₂ 10-25, B₂O₃ 2-20, ZnO 3-15, Bi₂O₃ 20-55, Na₂O 1-10;
EP 0 803 480 A (in Gew.-%): SiO₂ 10-25, B₂O₃ 20-40, ZnO 10-50, Bi₂O₃ 0-15, Na₂O 7-10;
US 5,714,420 (in Gew.-%): SiO₂ 20-35, B₂O₃ 5-15, ZnO 5-45, Bi₂O₃ 10-50, Na₂O.

Gemäß einer weiteren Ausführungsform können die Al-pasten zusätzlich pulverförmige Sinterhilfsmittel in einer Menge bis 10 Gew.-%, vorzugsweise bis 6 Gew.-% enthalten. Unter Sinterhilfsmitteln werden alle Stoffe verstanden, welche bei gegebener Sintertemperatur zu einem höheren Grad der Sinterung führen. Beispiele für Sinterhilfsmittel sind Metalle, wie Zn, Mg, B, Si, insbesondere Zink und Magnesium, Fluoride, wie Cryolith (AlF₃ · 3 NaF), NaF, MgF₂ sowie Kohlenstoff. Die Wirkung der Sinterhilfsmittel kann in der Schmelzpunktserniedrigung und/oder auf ihrer reduzierenden Wirkung während des Brands liegen.

Das organische Medium dient der Dispergierung des Al-Pulvers, der Glasfritte/n und, soweit anwesend, der/des Sinterhilfsmittels. Das Medium kann flüssig sein oder thermoplastisch, also erst bei erhöhter Temperatur flüssig werden. Bevorzugt werden flüssige organische Medien, welche ein oder mehrere Polymere (= Bindemittel) und/oder ein oder mehrere Lösungsmittel enthalten.

Im Prinzip kann das Medium auch wässrig sein, jedoch ist es dann zweckmäßig, wenn es zum Zwecke der Vermeidung einer Reaktion zwischen Aluminium und Wasser zusätzlich mindestens eine Verbindung aus der Reihe mehrwertiger Säuren, wie Maleinsäure oder sein Anhydrid, Bernsteinsäure, Polyacrylsäure, Borsäure, Natriumdihydrogenphosphat, Natriummetasilicat oder Natriumtriphosphat enthält.

Besonders bevorzugt enthält das Medium sowohl ein Bindemittel als auch mindestens ein organisches Lösungsmittel. Der Bindemittelgehalt wird so gewählt, dass nach dem Trocknen der Al-Paste ein grifffester Film resultiert. Besonders geeignet ist eine Bindemittelmenge im Bereich von 0,5 bis 10 Gew.-%, insbesondere 1 bis 5 Gew.-%, bezogen auf die Aluminiumpaste.

Die Bindemittelauswahl ist wenig kritisch, sofern sie sich unter den Brennbedingungen zersetzen und/oder verbrennen und dabei vollständig verflüchtigen. Geeignet sind beispielsweise Celluloseether, Acryl- und Methacrylsäureester, Naturharze, Kolophoniumharze und modifizierte Alkydharze.

Bei den organischen Lösungsmitteln als Bestandteil des Mediums handelt es sich um solche, welche sich beim Brand blasenfrei verflüchtigen und, soweit anwesend, das Bindemittel lösen können, und die Einstellung einer geeigneten Verarbeitungsviskosität der Aluminiumpaste ermöglichen. Beispiele sind Terpenalkohole und Terpenkohlenwasserstoff; Glykole und Diglykole sowie Ether und Ester derselben; cyclische und verzweigte Kohlenwasserstoffe, wie Isoparaffine mit einem Siedepunkt im Bereich von 160 bis 220 °C; Alkohole, Ether und Ester mit einem Siedepunkt im Bereich von 70 bis 250 °C, insbesondere 100 bis 220 °C. Die Einsatzmenge Lösungsmittel richtet sich nach der gewünschten Viskosität und liegt im Bereich von 10 bis 35 Gew.-%, vorzugsweise im Bereich von 10 bis 30 Gew.-%. Besonders bevorzugt enthält die Al-Paste 15 bis 25 Gew.-% eines Mediums aus einem Polymeren und einem oder mehreren Lösungsmitteln. Die erfindungsgemäß zu verwendende Al-Paste lässt sich in für keramische Druckpasten üblicher Weise herstellen, nämlich durch intensives Mischen der Komponenten, beispielsweise in einem Dreiwalzenstuhl, Dispergator oder in einer Kugelmühle.

Vorzugsweise handelt es sich bei dem Substrat um Glasscheiben, insbesondere solche für Kraftfahrzeuge. Weitere Substrate sind emaillierter Stahl, wobei unter "Stahl" Stahle beliebiger Zusammensetzung verstanden werden. Besonders bevorzugt erfolgt der Brand bei einer Temperatur im Bereich von 550 bis 700 °C, insbesondere 590 bis 690 °C. Auf Glasscheiben für Automobile wird die Al-Paste unter etwa gleichen Bedingungen eingebrannt, wie dies bei Glasfarben üblich ist, also im Schockbrand bei 640 bis 690 °C innerhalb 1 bis 10 Minuten, besonders 4 bis 6 Minuten.

Der Auftrag der erfindungsgemäßen Aluminiumpaste erfolgt mittels üblicher Verfahren, wie sie zur Herstellung von Dekoren auf Glas oder Keramik bekannt sind. Es handelt sich um übliche direkte und indirekte Druckverfahren, insbesondere Siebdruckverfahren. Auch Auftrag durch Spritzen, Tauchen oder mittels anderer Dekorauftragstechniken ist möglich.

Ein weiterer Gegenstand der Erfindung ist ein beschichtetes Substrat, das dadurch gekennzeichnet ist, dass das Substrat Glas ist, die Beschichtung 60 bis 90 Gew.-% Aluminium enthält und der spezifische Widerstand der Leitfähigkeitsschicht im Bereich von 10 bis 70 µOhm · cm liegt.

Wie bereits zuvor dargelegt, ist es möglich, auch solche beschichtete Substrate zu erzeugen, welche eine höhere Leitfähigkeit, entsprechend einem niedrigeren spezifischen Widerstand und dennoch hervorragend Haftung aufweisen. Besonders bevorzugte mit einer Aluminiumbeschichtung beschichtete Glassubstrate sind durch einen spezifischen Widerstand im Bereich von 20 bis 50 µOhm · cm und einem Kratzwiderstand von mindestens 20 N gekennzeichnet.

Die erfindungsgemäße Beschichtung auf Glas kann als Alternative zu üblichen Leitungsbahnen für Antennen und Scheibenheizungen dienen und damit die derzeit üblichen Silberleitbahnen ersetzen. Damit wird auch das von Ag-Beschichtungen bekannte, durch Ag-Migration verursachte Vergilbungsproblem vermieden. Eine erfindungsgemäße Beschichtung auf emailliertem Stahl kann als Flächenheizung verwendet werden.

Die nachfolgenden Beispiele verdeutlichen die Erfindung.

### Referenz-Beispiel 1

Hergestellt wurde eine homogene Paste aus
(i) 54 Gew.-% Aluminiumpulver mit d₅₀ = 5 µm und einer spezifischen Oberfläche von 1,1 m²/g,
(ii) 14 Gew.-% Bleiborosilikatfritte mit d₅₀ = 2 µm und einer Halbkugeltemperatur von 470 °C,
(iii) 30 Gew.-% Medium aus Ethylcellulose, gelöst in Terpineol und Butyldiglykolacetat (Bindemittelgehalt im Medium 3 Gew.-%),
(iv) 2 Gew.-% Zinkpulver.

Die Paste wurde mittels Siebdruck als 25 µm dicker Film auf ein Soda-Kalk-Glas aufgetragen und nach dem Trocken bei 720 °C unter Luft gebrannt.

Der spezifische Widerstand der eingebrannten Leiterbahn betrug 70 µOhm · cm. Die Haftung war gut.

### Referenz-Beispiel 2

Die Paste des Beispiels 1 wurde auf emailliertem Stahl aufgetragen. Der spezifische Widerstand betrug 70 µOhm · cm und die Haftung war sehr gut.

### Beispiel 3

Hergestellt wurde in üblicher Weise eine Aluminiumpaste aus (i) Aluminiumpulver (d₅₀ = 5 µm, d₉₀ = 13 µm und d₁₀ = 2 µm), (ii) einer Zinkborosilikatfritte (in Gew.-%): SiO₂ 13 %, ZnO 42 %, B₂O₃ 25 %, Na₂O 13 % und Al₂O₃ 6 %; d₅₀ = 1,5 µm, d₉₀ = 6,1 µm und d₁₀ = 0,5 µm; Erweichungsbeginn = 530 °C und (iii) einem Medium. Das Medium enthielt als Bindemittel Hydroxypropylcellulose in einer Menge von 5 Gew.-% und als Lösungsmittel Diethylenglykolmono-n-butylether. Die Paste enthielt stets 25 Gew.-% Medium. Variiert wurde der Fritte- und Al-Gehalt, wobei die Summe 75 Gew.-% betrug. Mittels Siebdruck wurde eine Glasschmelze bedruckt. Der Brand erfolgt im Temperaturbereich von 665 bis 680 °C durch Schockbrand.

Tabelle 1 zeigt den spezifischen Widerstand in Abhängigkeit vom Frittegehalt in der Paste bei unterschiedlicher Brenntemperatur. Der niedrigste spezifische Widerstand wird bei einem Frittegehalt von 12 Gew.-% und Al-gehalt von 63 Gew.-% erhalten. Die Veränderung des spezifischen Widerstands in Abhängigkeit von der Brenntemperatur im Bereich von 665 bis 680 °C war sehr gering.

**Tabelle 1**

| Glasfritte (Gew.-% in der Paste) | spez. Widerstand (µOhm · cm) | | | |
|---|---|---|---|---|
| | 665 °C | 670 °C | 675 °C | 680 °C |
| 9 | 29 | 26 | 25 | 25 |
| 12 | 24 | 24 | 23,5 | 23,5 |
| 15 | 27 | 26 | 26 | 26,5 |
| 18 | 30 | 30 | 30 | 30 |
| 21 | 33 | 33 | 35 | 34 |
| 24 | 43 | 45 | 43 | 43 |

Die Haftung wurde als Kratzwiderstand mittels einer Erichsen-Nadel bestimmt. Diese wurde über eine Leiterbahn geführt. Die Haftung betrug bei 9 % Glasfritte 5 N, bei 12 % Glasfritte gleich oder größer 20 N und bei höherem Gehalt über 20 N (methodisch bedingt waren nur Werte bis 20 N messbar). Die Haftfestigkeit und der spezifische Widerstand bleiben auch nach mehrwöchiger Lagerung in der Klimakammer (90 % rel. Feuchte, 70 °C) weitgehend konstant.

### Referenz-Beispiel 4

Analog Beispiel 3 wurden Pasten mit jeweils 25 Gew.-% Medium erzeugt, wobei anstelle der in Beispiel 3 eingesetzten Glasfritte eine Bismutborosilikatfritte mit 54 Gew.-% Bi₂O₃ verwendet wurde. Der d₅₀-Wert betrug 1,5 µm; Erweichungsbeginn = 550 °C.

Tabelle 2 zeigt den spezifischen Widerstand und die Haftung in Abhängigkeit vom Frittegehalt. Eingebrannt wurde 4 Minuten bei 680 °C.

**Tabelle 2**

| Frittegehalt (%) | spez. Widerstand (µOhm · cm) | Haftung (N) |
|---|---|---|
| 4,6 | 72 | 1 |
| 9,2 | 52 | 2 |
| 18,5 | 52 | 10 |
| 21,5 | 45 | ≥ 20 |
| 24,6 | 55 | > 20 |
| 27,7 | 78 | > 20 |

### Referenz-Beispiel 5

Analog Beispiel 3 wurde eine Paste hergestellt, auf Glas aufgedruckt und bei 680 °C eingebrannt. Einziger Unterschied zu Beispiel 3 war der Einsatz einer Pb-, Bi- und Zn-freien Borosilikatfritte (Produkt-Nr. 501006 der Cerdec AG; d₅₀-Wert = 2,2 µm, Erweichungsbeginn = 580 °C). Wie üblich wurde angepastet, auf Glas gedruckt und bei 680 °C eingebrannt. Tabelle 3 zeigt den spezifischen Widerstand und die Haftung in Abhängigkeit vom Frittegehalt in der Paste (Fritte + Al stets 75 Gew.-%).

**Tabelle 3**

| Fritte (Gew.-%) | spez. Widerstand (µOhm · cm) | Haftung (N) |
|---|---|---|
| 4,6 | 50 | 5 |
| 9,2 | 55 | 5 |
| 15,4 | 45 | ≥ 20 |
| 18,5 | 65 | > 20 |
| 27,7 | 160 | > 20 |

Auch unter Einsatz dieser Fritte sind bei etwa 15 Gew.-% Fritte und 60 Gew.-% Aluminium Al-Beschichtungen mit guter Haftung (≥ 20 N) und niedrigem spez. Widerstand (45 µOhm · cm) erhältlich.

## Patentansprüche

1. Verfahren zur Herstellung einer leitfähigen Beschichtung, insbesondere Leiterbahnen, auf einem Substrat aus der Reihe Glas und emailliertem Stahl; umfassend Aufbringen einer Schicht aus einer ein Metallpulver, mindestens eine bleifreie Glasfritte und ein flüssiges oder thermoplastisches Medium enthaltenden Paste auf das Substrat und Einbrennen der Beschichtung bei einer Temperatur im Bereich von 500 bis 750 °C,
**dadurch gekennzeichnet,**
**dass** man eine siebdruckfähige Aluminiumpaste verwendet, welche
(i) Aluminiumpulver mit einem d₅₀-Wert im Bereich von 1 bis 10 µm in einer Menge von 40 bis 80 Gew.-%,
(ii) eine oder mehrere Glasfritten mit einem Erweichungsbeginn im Bereich von 400 bis 700 °C und einem d₅₀-Wert im Bereich von 1 bis 10 µm in einer Menge von 5 bis 40 Gew.-%, wobei eine oder mehrere Glasfritten eine Zusammensetzung mit
10-25 Gew.-% SiO₂,
20-40 Gew.% B₂O_{3,}
10-50 Gew.-% ZnO,
0-15 Gew.-% Bi₂O₃,
7-15 Gew.-% Na₂O,
3-8 Gew.-% Al₂O₃,
0-2.Gew.-% F und gegebenenfalls fakultativen Oxiden aufweisen,
(iii) ein flüssiges oder thermoplastisches Medium aus einem oder mehreren Polymeren und/oder Lösungsmitteln in einer Gesamtmenge von 10 bis 35 Gew.-%,
(iv) Sinterhilfsmittel in Pulverform in einer Menge von 0 bis 10 Gew.-% und
(v) 0 bis 40 Gew.-% Silberpulver
enthält.

2. Verfahren nach Anspruch 1,
**dadurch gekennzeichnet,**
**dass** die Aluminiumpaste im wesentlichen silberfrei ist und
i) 50 bis 75 Gew.-% Aluminiumpulver mit einem d₅₀-Wert im Bereich von 1 bis 8µm.
(ii) 5 bis 30 Gew.-% einer oder mehrerer Glasfritten mit einem d₅₀-Wert im Bereich von 0,5 bis 5 µm,
(iii) 15 bis 25 Gew.-% organisches Medium und
(iv) 0 bis 6 Gew.-% eines oder mehrerer pulverförmiger Sinterhilfsmittel aus der Reihe Zink, Magnesium, Bor, Mangan und Kohlenstoff
enthält.

3. Verfahren nach Anspruch 1 oder 2,
**dadurch gekennzeichnet,**
**dass** die Aluminiumpaste im wesentlichen kugelförmiges Aluminiumpulver mit einem d₅₀-Wert im Bereich von 1 bis 8 µm, einem d₉₀-Wert von kleiner 15 µm und einem d₁₀-Wert von größer 0,5 µm enthält.

4. Verfahren nach einem der Ansprüche 1 bis 3,
**dadurch gekennzeichnet,**
**dass** die Aluminiumpaste eine oder mehrere Glasfritten mit einem d₅₀-Wert im. Bereich von 1 bis 5 µm, einem d₉₀-Wert von kleiner 10 µm und einem d₁₀-Wert von größer 0,2 µm enthält.

5. Verfahren nach einem der Ansprüche 1 bis 4,
**dadurch gekennzeichnet,**
**dass** die Aluminiumpaste eine oder mehrere zinkhaltige Borosilikatfritten mit einem Erweichungsbeginn im Bereich von 420 bis 580 °C in einer Menge von 9 bis 25 Gew.%, insbesondere 10 bis 23 Gew.-%, enthält, die eine Zusammensetzung mit 10-25 Gew.% SiO_{2,}
20-40 Gew.-% B₂O₃,
10-50 Gew.-% ZnO,
0-15 Gew.-% Bi₂O_{3,}
7-15 Gew.-% Na₂O,
3-8 Gew.-% Al₂O₃,
0-2 Gew.% F und gegebenenfalls fakultativen Oxiden aufweisen.

6. Verfahren nach einem der Ansprüche 1 bis 5,
**dadurch gekennzeichnet,**
**dass** man die Aluminiumpaste mittels direkten oder indirekten Siebdruck auf das Substrat aufträgt.

7. Verfahren nach einem der Ansprüche 1 bis 6,
**dadurch gekennzeichnet,**
**dass** man Automobilglas mit einer Aluminiumpaste gemäß Anspruch 2 und/oder gemäß Anspruch 5 beschichtet und die Beschichtung durch einen Brand bei einer Temperatur im Bereich von 550 bis 700 °C, insbesondere 590 bis 690 °C, einbrennt.

8. Mit einer leitfähigen Beschichtung aus im wesentlichen einem Metall und einem Glas versehenes Substrat aus der Reihe Glas und emaillierter Stahl,
**dadurch gekennzeichnet,**
**dass** das Substrat gemäß einem Verfahren gemäß den Ansprüchen 1 bis 7 erhältlich ist, die leitfähige Beschichtung 55 bis 95 Gew.-% Aluminium enthält und der spezifische Widerstand der Beschichtung kleiner 100 µOhm·cm ist.

9. Beschichtetes Substrat nach Anspruch 8,
**dadurch gekennzeichnet,**
**dass** das Substrat Glas ist, die Beschichtung 60 bis 90 Gew.-% Aluminium enthält und der spezifische Widerstand der Leitfähigkeitsschicht im Bereich von 10 bis 70 µOhm·cm liegt.

## Claims

1. Method of producing a conductive coating, in particular conductor tracks, on a substrate selected from the group comprising glass and enamelled steel, which involves applying a layer of paste containing a metal powder, at least one lead-free glass frit and a liquid or thermoplastic medium to the substrate and burning in the coating at a temperature in the range of 500 to 750°C,
**characterised in that**
a screen-printable aluminium paste is used, containing
(i) aluminium powder with a d₅₀ value in the range of 1 to 10 µm in a quantity of 40 to 80 % by weight,
(ii) one or more glass frits which start to plasticise in the range of 400 to 700°C and have a d₅₀ value in the range of 1 to 10 µm in a quantity of 5 to 40 % by weight, and one or more glass frits have a composition comprising
10-25 % by weight of SiO₂,
20-40 % by weight of B₂O₃,
10-50 % by weight of ZnO,
0-15 % by weight of Bi₂O₃,
7-15 % by weight of Na₂O,
3-8 % of Al₂O₃,
0-2 % by weight of F and optionally facultative oxides,
(iii) a liquid or thermoplastic medium containing one or more polymers and/or solvents in a total quantity of 10 to 35 % by weight,
(iv) sintering aids in powdered form in a quantity of 0 to 10 % by weight and
(v) 0 to 40 % by weight of silver powder.

2. Method as claimed in claim 1,
**characterised in that**
the aluminium paste is essentially free of silver and contains
(i) 50 to 75 % by weight of aluminium powder with a d₅₀ value in the range of 1 to 8 µm,
(ii) 5 to 30 % by weight of one or more glass frits with a d₅₀ value in the range of 0.5 to 5 µm,
(iii) 15 to 25 % by weight of organic medium and
(iv) 0 to 6 % by weight of one or more powdered sintering aids from the group comprising zinc, magnesium, boron, manganese and carbon.

3. Method as claimed in claim 1 or 2,
**characterised in that**
the aluminium paste contains essentially spherically shaped aluminium powder with a d₅₀ value in the range of 1 to 8 µm, a d₉₀ value of less than 15 µm and a d₁₀ value greater than 0.5 µm.

4. Method as claimed in one of claims 1 to 3,
**characterised in that**
the aluminium paste contains one or more glass frits with a d₅₀ value in the range of 1 to 5 µm, a d₉₀ value of less than 10 µm and a d₁₀ value greater than 0.2 µm,

5. Method as claimed in one of claims 1 to 4,
**characterised in that**
the aluminium paste contains one or more zinc-containing borosilicate frits which start to plasticise in the range of 420 to 580°C in a quantity of 9 to 25 % by weight, in particular 10 to 23 % by weight, with a composition comprising
10-25 % by weight of SiO₂,
20-40 % by weight of B₂O₃,
10-50 % by weight of ZnO,
0-15 % by weight of Bi₂O₃,
7-15 % by weight of Na₂O,
3-8 % by weight of Al₂O₃,
0.2 % by weight of F and optionally facultative oxides.

6. Method as claimed in one of claims 1 to 5,
**characterised in that**
the aluminium paste is applied to the substrate directly or indirectly by screen printing.

7. Method as claimed in one of claims 1 to 6,
**characterised in that**
automobile glass is coated with an aluminium paste as claimed in claim 2 and/or as claimed in claim 5 and the coating is burnt in by a burning process at a temperature in the range of 550 to 700° C, in particular 590 to 690° C.

8. Substrate from the group comprising glass and enamelled steel provided with a conductive coating essentially comprising a metal and a glass,
**characterised in that**
the substrate is obtained by a method as claimed in claims 1 to 7, the conductive coating contains 55 to 95 % by weight of aluminium and the specific resistance of the coating is less than 100 µOhm·cm.

9. Coated substrate as claimed in claim 8,
**characterised in that**
the substrate is glass, the coating contains 60 to 90 % by weight of aluminium and the specific resistance of the conductive layer is in the range of 10 to 70 µOhm·cm.

## Revendications

1. - Procédé de fabrication d'un revêtement conducteur, en particulier de pistes conductrices, sur un substrat de la série du verre et de l'acier émaillé, comprenant l'application sur le substrat d'une couche d'une pâte contenant une poudre métallique, au moins une fritte de verre exempte de plomb et un milieu liquide ou thermoplastique, et la cuisson du revêtement à une température se situant dans la plage de 500 à 750°C,
**caractérisé par le fait**
**que** l'on utilise une pâte d'aluminium apte à être sérigraphiée, laquelle contient :
(i) de la poudre d'aluminium présentant une valeur de d₅₀ se situant dans la plage de 1 à 10 µm dans une quantité de 40 à 80 % en poids ;
(ii) une ou plusieurs frittes de verre présentant un début de ramollissement se situant dans la plage de 400 à 700°C et une valeur de d₅₀ se situant dans la plage 1 à 10 µm dans une quantité de 5 à 40 % en poids, une ou plusieurs frittes de verre présentant une composition avec :
10-25 % en poids de SiO₂,
20-40 % en poids de B₂O₃,
10-50 % en poids de ZnO,
0-15 % en poids de Bi₂O₃,
7-15 % en poids de Na₂O,
3-8 % en poids d'Al₂O₃,
0-2 % en poids de F et, le cas échéant, facultativement des oxydes,
(iii) un milieu liquide ou thermoplastique d'un ou plusieurs polymères et/ou solvants dans une quantité totale de 10 à 35 % en poids,
(iv) un auxiliaire de frittage sous forme pulvérulente dans une quantité de 0 à 10 % en poids, et
(v) 0 à 40 % en poids de poudre d'argent.

2. - Procédé selon la revendication 1,
**caractérisé par le fait,**
**que** la pâte d'aluminium est sensiblement exempte d'argent et contient :
(i) 50 à 75 % en poids de poudre d'aluminium avec une valeur de d₅₀ dans la plage de 1 à 8 µm ;
(ii) 5 à 30 % en poids d'une ou plusieurs frittes de verre ayant une valeur de d₅₀ se situant dans la plage de 0,5 à 5 µm :
(iii) 15 à 25 % en poids d'un milieu organique, et
(iv) 0 à 6 % en poids d'un ou plusieurs auxiliaires de frittage sous forme de poudre de la série du zinc, magnésium, du bore, du manganèse et du carbone.

3. - Procédé selon l'une des revendications 1 ou 2,
**caractérisé par le fait,**
**que** la pâte d'aluminium contient essentiellement de la poudre d'aluminium sous forme de billes avec une valeur de d₅₀ se situant dans la plage de 1 à 8 µm, une valeur de d₉₀ de moins de 15 µm et une valeur de d₁₀ de plus de 0,5 µm.

4. - Procédé selon l'une des revendications 1 à 3,
**caractérisé par le fait,**
**que** la pâte d'aluminium contient une ou plusieurs frittes de verre avec une valeur de d₅₀ se situant dans la plage de 1 à 5 µm, une valeur de d₉₀ de moins de 10 µm et une valeur de d₁₀ de plus de 0,2 µm.

5. - Procédé selon l'une des revendications 1 à 4,
**caractérisé par le fait,**
**que** la pâte d'aluminium contient une ou plusieurs frittes de borosilicate contenant du zinc avec un début de ramollissement se situant dans la plage de 420 à 580°C dans une quantité de 9 à 25 % en poids, en particulier de 10 à 23 % en poids, qui présentent une composition avec :
10-25 % en poids de SiO₂,
20-40 % en poids de B₂O₃,
10-50 % en poids de ZnO,
0-15 % en poids de Bi₂O₃,
7-15 % en poids de Na₂O,
3-8 % en poids d'Al₂O₃,
0-2 % en poids de F et le cas échéant des oxydes facultatifs.

6. - Procédé selon l'une des revendications 1 à 5, **caractérisé par le fait que** l'on applique la pâte d'aluminium au moyen d'une sérigraphie directe ou indirecte sur le substrat.

7. - Procédé selon l'une des revendications 1 à 6, **caractérisé par le fait,**
**que** l'on revêt du verre pour automobiles par une pâte d'aluminium telle que définie à la revendication 2 et/ou telle que définie à la revendication 5 et que l'on cuit le revêtement par une cuisson à une température se situant dans la plage de 550 à 700°C, en particulier de 590 à 690°C.

8. Substrat de la série du verre et de l'acier émaillé doté d'un revêtement conducteur essentiellement à base d'un métal et d'un verre,
**caractérisé par le fait,**
**que** le substrat est obtenu conformément à un procédé tel que défini à l'une des revendications 1 à 7, le revêtement conducteur contient 55 à 95 % en poids d'aluminium et la résistance spécifique du revêtement est inférieure à 100 µOhm.cm.

9. - Substrat revêtu selon la revendication 8,
**caractérisé par le fait,**
**que** le substrat est du verre, le revêtement contient 60 à 90 % en poids d'aluminium et la résistance spécifique de la couche de conductivité se situe dans la plage de 10 à 70 µOhm.cm.
